(19) **Europäisches Patentamt / European Patent Office / Office européen des brevets**

(11) **EP 4 363 875 B1**

(12) **EUROPÄISCHE PATENTSCHRIFT**

(45) Veröffentlichungstag und Bekanntmachung des Hinweises auf die Patenterteilung:
**25.09.2024 Patentblatt 2024/39**

(21) Anmeldenummer: **23764302.8**

(22) Anmeldetag: **30.08.2023**

(51) Internationale Patentklassifikation (IPC):
**G01R 33/30** (2006.01)     **G01R 33/31** (2006.01)

(52) Gemeinsame Patentklassifikation (CPC):
**G01R 33/30; G01R 33/31**

(86) Internationale Anmeldenummer:
**PCT/EP2023/073811**

(87) Internationale Veröffentlichungsnummer:
**WO 2024/061584 (28.03.2024 Gazette 2024/13)**

(54) **HALTERUNG VON NMR-MESSPROBEN IN EINEM PLATZ-BESCHRÄNKTEN NMR-SPEKTROMETER**

HOLDING OF NMR MEASUREMENT SAMPLES IN A SPACE-RESTRICTED NMR SPECTROMETER

MAINTIEN D'ÉCHANTILLONS DE MESURE RMN DANS UN SPECTROMÈTRE RMN À ESPACE RESTREINT

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **22.09.2022 DE 102022210010**

(43) Veröffentlichungstag der Anmeldung:
**08.05.2024 Patentblatt 2024/19**

(73) Patentinhaber: **Bruker Switzerland AG**
**8117 Fällanden (CH)**

(72) Erfinder:
• **MEISTER, Roger**
**8132 Hinteregg (CH)**

• **KNECHT, Daniel**
**8604 Volketswil (CH)**
• **MAYER, Markus**
**8625 Gossau (CH)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**DE-A1- 102012 217 601     DE-A1- 102016 203 891**
**DE-A1- 102019 212 508**

EP 4 363 875 B1

**Beschreibung**

Die Erfindung betrifft ein NMR-Spektrometer mit einem NMR-Magnetsystem, welches eine Permanentmagnetvorrichtung zur Erzeugung eines $B_0$ Feldes in einem Messvolumen sowie eine Bohrung durch das Magnetzentrum zum Einführen einer NMR-Messprobe in einem im Wesentlichen zylindrischen, zumindest an seiner Unterseite geschlossenen Probenröhrchen aufweist, sowie mit einer HF-Spule zur Anregung der Kernspins in der NMR-Messprobe und mit einem Temperiersystem, wobei die HF-Spule außerhalb eines zylindrischen Temperierrohrs angeordnet ist, welches durch das Messvolumen verläuft und in welches das Probenröhrchen für eine NMR-Messung derart eingebracht werden kann, dass zwischen dem Innenumfang des zylindrischen Temperierrohrs und dem Außenumfang des Probenröhrchens ein durchgängiger ringförmiger Luftspalt besteht, durch welchen zumindest im NMR-Messbetrieb aus dem Temperiersystem durch einen Gaseinlass Temperiergas zum Temperieren der NMR-Messprobe im Probenröhrchen geleitet werden kann.

Ein solches NMR-Spektrometer mit einer Permanentmagnetanordnung und einer Einrichtung zur Temperierung der NMR-Messprobe mittels Temperiergas ist aus der DE 10 2019 212 508 A1 (= Referenz [1]) bekannt geworden. Bereits die DE 10 2004 029 633 B4 (= Referenz [2]) beschreibt eine NMR-Apparatur mit einem NMR-Spektrometer zum sequentiellen Untersuchen mehrerer aus einem Magazin in einem Kälteschrank pneumatisch in die Mess-Position im Spektrometer zugeführter NMR-Messproben, die während des Transports in einer Zuführungsleitung genau auf die gewünschte höhere Messtemperatur gebracht werden.

Eine Transporteinrichtung zur pneumatischen Beförderung von während der Messung temperierten NMR-Messproben aus einem Bereich außerhalb eines NMR-Spektrometers durch einen rohrförmigen Transportkanal in das NMR-Spektrometer und von dort -nach Durchführung einer NMR-Messung an den NMR-Messproben- wieder nach außerhalb des NMR-Spektrometers ist beschrieben in DE 10 2018 205 535 B3 (= Referenz [3]).

Ein NMR-Spektrometer mit Schnellwechselsystem für die NMR-Messproben ist bekannt aus der EP 3 715 893 B1 (= Referenz [4]).

In der US 10,436,859 B2 (= Referenz [5]) wird eine Vorrichtung und ein Verfahren zum Einführen von NMR-Messproben in ein NMR-Spektrometer sowie zum Herausführen aus dem Spektrometer mittels Druckgas beschrieben.

Die EP 3 561 533 B1 (= Referenz [6]) offenbart eine NMR-Messprobe, die zur NMR-Messung in ein NMR-Spektrometer ein- und danach wieder herausbefördert wird. Während der Messung wird die Messprobe durch verschiedene thermische Abschirmungen sowie mittels Temperiergas auf einer gewünschten Temperatur gehalten.

Hintergrund der Erfindung

Die vorliegende Erfindung befasst sich allgemein mit der Temperierung von NMR-Messproben im Betrieb, insbesondere für Benchtop-NMR-Geräte mit Permanentmagnetsystemen. Bei Permanentmagneten ist das erzeugte Magnetfeld abhängig von den ferromagnetischen Eigenschaften des verwendeten Permanentmagnet-Materials. Diese Eigenschaften wiederum sind stark temperaturabhängig. Für hochauflösende NMR mit sub-Hertz Linienbreiten ist es wichtig, die Permanentmagnetanordnung thermisch sehr präzise zu regulieren, um eine Drift oder Schwankung des B0-Feldes zu vermeiden, die zu Resonanzlinienverbreiterungen bei der Akkumulation von Spektren zur Erhöhung des Signal-zu-Rausch-Verhältnis (S/N) oder Distorsionen von Linienformen bei Veränderungen der Magnetfeldstärke über die Zeitdauer einer Akquisition hinweg führen können.

In NMR-Benchtop Spektrometern werden daher die NMR-Messproben mit Hilfe eines Gasstroms temperiert, derzeit zwischen 25°C und 60°C. Diese Funktion nennt man in den Geräten "Adjustable Temperature" (="AT bzw. AT-Gasstrom").

Zentrale Problematik bei dieser Benchtop-Ausführung mit Permanentmagneten ist der zur Verfügung stehende sehr geringe Bauraum für die Automatisierung. Dadurch ist es erforderlich, sämtliche Zuleitungen für Hochfrequenz (HF), Shimsystem und Locksample in den Luftspalt zwischen den Magnetpolen zu führen. Der Luftspalt ist jedoch aufgrund der Homogenitätserfordernisse für das NMR-Magnetfeld relativ eng ausgeführt.

Zusätzlich erfordert die Verwendung von Permanentmagneten in der NMR-Spektroskopie eine sehr präzise Temperierung der NMR-Magnete, da geringste Temperaturschwankungen zu einer Felddrift führen und der Spektrometer die Resonanzfrequenz ändert (siehe etwa auch Referenz [1]). Dies bedeutet, dass zwischen der NMR-Messprobe, die beispielsweise bei 60°C vermessen wird, und dem B0 Magneten, der typischerweise bei Raumtemperatur, idealerweise auf Millikelvin, gehalten wird, ein Abstand von lediglich 6mm gegeben ist, in welchem ein Temperaturgradient von > 30K vorhanden ist.

Die Temperierung der NMR-Messprobe wird durch einen sogenannten «direct flow» erreicht. Dies bedeutet, dass die NMR-Messprobe mit auf die gewünschte Temperatur konditioniertem AT-Gasstrom direkt umströmt wird. Beim Prinzip «direct flow» wird die Temperiergas dabei direkt zwischen der NMR-Messprobe und dem kleinsten Tubing von unten nach oben geführt.

Durch das sehr kleine Spaltmaß von 0,1-0,3mm zwischen der NMR-Messprobe und dem kleinsten Tubing, ist der Luftkanal sehr dünn ausgebildet. Durch diesen dünnen Kanal entsteht aufgrund der Temperierluft unterhalb der NMR-Messprobe ein Staudruck. Dieser Staudruck verursacht, dass die NMR-Messprobe aus ihrer Messposition im NMR-Spektrometer angehoben wird.

In der eingangs zitierten Referenz [1] wird eine gattungsgemäße Anordnung mit den eingangs genannten Merkmalen sowie ein Verfahren zur Erzeugung eines homogenen Magnetfelds beschrieben. Allerdings spricht die Referenz [1] das oben geschilderte Problem mit dem Staudruck durch das Temperiergas nicht an und bietet auch keine Abhilfe hierfür.

## Aufgabe der Erfindung

Der vorliegenden Erfindung liegt demgegenüber die Aufgabe zugrunde, ein Temperiersystem für ein NMR-Magnetsystem der eingangs beschriebenen Art mit möglichst unaufwändigen technischen Mitteln dahingehend zu verbessern, dass die oben diskutierten Probleme bekannter gattungsgemäßer Anordnungen mit dem Staudruck durch das AT-Temperiergas vermieden werden.

## Kurze Beschreibung der Erfindung

Diese Aufgabe wird durch die vorliegende Erfindung auf ebenso überraschend einfache wie wirkungsvolle Weise dadurch gelöst, dass bei einem NMR-Spektrometer der eingangs definierten Art an dem im NMR-Messbetrieb dem Gaseinlass gegenüberliegenden Ende des Probenröhrchens eine relativ zum Probenröhrchen in dessen Messposition bewegliche Haltevorrichtung im NMR-Spektrometer installiert ist, dass die Haltevorrichtung so ausgestaltet ist, dass sie in einer ersten Betriebsstellung das Probenröhrchen nicht berührt, um dessen Einführung in seine Messposition im NMR-Spektrometer zu ermöglichen, dass sie in einer zweiten Betriebsstellung das Probenröhrchen für die Durchführung der NMR-Messung an seinem Außenumfang kraftschlüssig und/oder formschlüssig mit einer axial auf das Probenröhrchen wirkenden Kraft bzw. Haftreibung $F_f$ in seiner Messposition hält, und dass sie in einer dritten Betriebsstellung das Probenröhrchen zur Entnahme aus dem NMR-Spektrometer wieder freigibt, und dass die Haltevorrichtung so ausgestaltet ist, dass in der zweiten Betriebsstellung gilt

$$F_f > F_{Stau} - F_{Gewicht},$$

wobei $F_{Stau}$ die vom Staudruck des im NMR-Messbetrieb auf das Probenröhrchen strömenden Temperiergases erzeugte Auftriebskraft auf das Probenröhrchen und $F_{Gewicht}$ die Gewichtskraft des Probenröhrchens bedeuten.

Bei der vorliegenden Erfindung geht es vor allem darum, mit möglichst einfachen Mitteln während des NMR-Messbetriebs eine sichere räumliche Fixierung der NMR-Messprobe in ihrer Messposition zu gewährleisten.

Dieses Ziel wird erfindungsgemäß insbesondere erreicht durch ein ganz speziell ausgebildetes bewegliches Haltelement, welches die NMR-Messprobe an ihrem Umfang durch einen Kraftschluss oder Formschluss in Position hält.

Besonders vorteilhaft lässt sich die vorliegende Erfindung einsetzen bei NMR-Spektrometern mit einer Permanentmagnetvorrichtung zur Erzeugung eines B0 Feldes im Messvolumen. Ein solches Spektrometer umfasst regelmäßig eine Temperiervorrichtung, um die zu vermessenden NMR-Messproben mit Hilfe eines AT-Gasstroms, welcher die jeweilige NMR-Messprobe von unten geblasen mit einer ausreichenden Flussrate anströmt, sodass sich kein Temperaturgradient in der NMR-Messprobe ausbildet.

Der AT-Gasstrom wird über eine Schlauch- oder Rohrverbindung in das Spektrometer geleitet und innerhalb des Spektrometers auf die gewünschte Temperatur gebracht. Im Spektrometer selbst wird der AT-Gasstrom durch einen Dewar geführt, der die temperatursensible Elektronik und die magnetfelderzeugenden Bauteile vom AT-Gasstrom isoliert. Der AT-Gasstrom wird in ein Rohr bzw. Spulenglas geführt, welches die NMR-Messprobe umgibt und auf welchem die ein B1-Feld erzeugende Spule angeordnet ist.

Aufgrund des begrenzten Bauraumes ist nur ein geringer Abstand zwischen der NMR-Messprobe und dem Spulenglas (0,1mm - 0,5mm). Dort ist eine Haltevorrichtung für die NMR-Messprobe angeordnet, welche die NMR-Messprobe in der Messposition hält, trotz des starken AT-Temperiergas-Flusses. Die Haltevorrichtung klemmt die NMR-Messprobe, in der Regel ein NMR-Röhrchen, und zwar derart, dass der Staudruck $F_{Stau}$ die NMR-Messprobe mit Sicherheit nicht axial verschieben oder gar auswerfen kann.

## Bevorzugte Ausführungsformen und Weiterbildungen der Erfindung

Die dritte Betriebsstellung des Probenröhrchens fällt bei besonders vorteilhaften Ausführungsformen der Erfindung mit der ersten Betriebsstellung identisch zusammen, was die NMR-Apparatur dann noch kompakter macht, weiter vereinfacht und mithin die Herstellungskosten verringert.

Ganz besonders bevorzugt ist eine Ausführungsform des erfindungsgemäßen NMR-Spektrometers, die sich dadurch auszeichnet, dass die Haltevorrichtung so gestaltet ist, dass eine Kontaktfläche zwischen dem Probenröhrchen und der Haltevorrichtung einen Reibungskoeffizienten $\mu > 0{,}3$ aufweist, und dass gilt

$$F_f = \mu \cdot F_{klemm},$$

wobei $F_{klemm}$ die radial auf das Probenröhrchen wirkende Klemmkraft und $\mu$ der Reibungskoeffizient sind.

Der Reibungskoeffizient muss ausreichend hoch sein, damit eine signifikante Axialkraft entsteht. Je höher der Reibungskoeffizient ist, desto geringer kann die Klemmkraft sein. Als sinnvolle Materialpaarung kann z.B. Glas mit Gummi- oder Silikonelastomer genannt werden.

Vorteilhaft sind auch Ausführungsformen der Erfindung, bei denen der durchgängige ringförmige Luftspalt zwischen dem Innenumfang des zylindrischen Temperierrohrs und dem Außenumfang des Probenröhrchens in der Messposition des Probenröhrchens eine radiale Öffnungsbreite zwischen 0,1 mm und 1 mm, vorzugsweise zwischen 0,15mm und 0,3mm aufweist.

Die NMR-Spule muss so nah wie möglich an der Probe sein. Jeder Zehntel Millimeter ändert die Empfindlichkeit des Spektrometers.

Weitere vorteilhafte Ausführungsformen der Erfindung zeichnen sich dadurch aus, dass das Temperiergas einen Volumenstrom von mindestens 1 l/min und maximal 20 l/min, vorzugsweise 3,5 l/min bis 12 l/min, während des NMR-Messbetriebs des NMR-Spektrometers aufweist.

Der große Volumenstrom hat zur Konsequenz, dass das Probenröhrchen durch den Staudruck herausbefördert wird. Ein Mindest-Volumenstrom ist aber erforderlich, um die Temperierzeit der NMR-Probe zu verringern und einen Temperaturgradienten in der Messprobe zu vermeiden oder zumindest zu minimieren.

Eine Klasse von Ausführungsformen der Erfindung ist dadurch gekennzeichnet, dass ein Probenwechsler zum automatisierten Beschicken des NMR-Spektrometers mit Probenröhrchen vorhanden ist, welcher ein Vorratsbehältnis zur Bevorratung einer Mehrzahl von Probenröhrchen und eine Vorrichtung zur Übergabe und Herausnahme der Proberöhrchen in das Messvolumen bzw. aus dem Messvolumen umfasst.

Dies dient einem nicht überwachten automatisierten Betrieb, ggf. auch einem Hochdurchsatz.

Bei bevorzugten Weiterbildungen dieser Klasse von Ausführungsformen wirkt die Haltevorrichtung gleichzeitig als Vorrichtung zur Übergabe und Herausnahme von Proberöhrchen, und das NMR-Spektrometers sowie der Probenwechsler sind vorzugsweise Bestandteile eines Automatensystems mit Robotergreifarm.

Eine gesonderte Haltevorrichtung ist dann nicht erforderlich, da der Greifarm gleichzeitig die Haltevorrichtung ist.

Vorteilhaft sind auch Ausführungsformen des erfindungsgemäßen NMR-Spektrometers, die dadurch gekennzeichnet sind, dass ein Dewar vorhanden ist, welcher eine vom Temperiersystem zum Gaseinlass führende Leitung zumindest teilweise umgibt.

Der Dewar ist wichtig, da das Spektrometer hochsensibel auf Temperaturänderungen reagiert. Insbesondere der Permanentmagnet sollte von der Betriebstemperatur nicht abweichen. Aber auch elektronische Komponenten und das Shimsystem sind temperiert und das bei sehr kleinem Bauraum.

Man muss die gesamte Elektronik möglichst von Temperaturschwankungen isolieren. Idealerweise reicht der Dewar bis hin zum Sample, damit der AT-Gasstrom isoliert ist von der Elektronik. Geheizt wird vorzugsweise im Dewar selbst, z.B. mit einer Heizwendel. In Verbindung mit gekühlter Luft (N$_2$), die von außen zugeführt wird, kann die Temperatur des AT-Gasstroms eingestellt werden.

Eine weitere Klasse von Ausführungsformen der Erfindung ist dadurch gekennzeichnet, dass ein erstes Sensorelement zur Bestimmung der Anwesenheit des Probenröhrchens innerhalb des NMR-Spektrometers vorhanden ist.

Vorzugsweise dient dieses Sensorelement zur Überprüfung der korrekten Einnahme der Messposition durch das Probenröhrchen, eventuell in Verbindung mit einer Markierung am Probenröhrchen.

Das Merkmal dient der Reproduzierbarkeit der Messungen im automatischen Betrieb, denn die korrekte Positionierung des Samples im Messbereich ist wesentlich bei der NMR-Messung. Wichtig ist auch die Detektion der Abwesenheit der Messprobe vor dem Beschicken mit einer neuen, damit es nicht zur Kollision der Probenröhrchen im Spektrometer und somit zum Bruch kommt.

Bei bevorzugten Weiterbildungen dieser Klasse von Ausführungsformen ist ein weiteres Sensorelement zur Bestimmung der aktuellen Betriebsstellung der Haltevorrichtung vorhanden.

Das weitere Sensorelement muss registrieren, dass das Sample in seiner Messposition fixiert ist. Außerdem zeigt der Sensor an, dass der Haltestift aktuell zurückgezogen ist, um das Beschicken mit einer Messprobe nicht zu blockieren.

Alternativ oder ergänzend kann bei anderen Ausführungsformen der Erfindung die Haltevorrichtung einen Haltekolben umfassen, der mittels Druckluft oder auch Motorgetrieben mit einer Kraft beaufschlagt werden kann, die dann den Haltekolben entgegen einer Rückstellkraft, insbesondere der Federkraft einer Rückstellfeder gegen das Probenröhrchen verschiebt.

Durch die Rückstellfeder ist die Haltevorrichtung in einer bevorzugten Position, wenn keine Druckluftbeaufschlagung gegeben ist. Die Position kann gewählt werden: entweder in der Klemmposition oder zurückgezogen.

Eine vorteilhafte Weiterbildung dieser Ausführungsformen zeichnet sich dadurch aus, dass der Haltekolben einen Haltestift aufweist, welcher in direkten mechanischen Kontakt mit dem Außenumfang des Probenröhrchens treten kann.

Durch den Einsatz eines Haltestifts kann das Material (in der Regel ein Elastomer), welches das Proberöhrchen hält, frei gewählt werden. Der Haltekolben selbst muss vom Material her fest sein, also mit größerem Elastizitätsmodul, wegen der Druckluftbeaufschlagung.

Ganz besonders einfach aufgebaut ist eine erste Gruppe von Ausführungsformen der Erfindung, bei welchen die Haltevorrichtung Haltewangen umfasst, die zumindest Teile des Außenumfangs des Probenröhrchens zangenartig festklemmen können, wobei die Haltewangen vorzugsweise als Spannzange oder als zwei Halbschalen ausgebildet sind, die das Probenröhrchen an seinem Außenumfang von beiden Seiten festhalten können.

Damit ergibt sich eine symmetrische Anpresskraft bei den Haltewangen und das Proberöhrchen wird gut zentriert.

Eine zweite Gruppe von Ausführungsformen des erfindungsgemäßen NMR-Spektrometers zeichnet sich dadurch aus, dass die Haltevorrichtung eine Irisblende umfasst.

Vorteilhaft ist eine ebenfalls symmetrische Anpresskraft durch die Irisblende. Das Proberöhrchen wird sogar noch besser zentriert als mit den Haltewangen.

Bei einer dritten Gruppe von Ausführungsformen weist die Haltevorrichtung ein Zustellelement auf, welches in der zweiten Betriebsstellung Deckel-artig über dem dem Gaseinlass gegenüberliegenden Ende des Probenröhrchens in axialer Richtung das Probenröhrchen von einer Bewegung aus der Messposition abhält.

Beispielsweise kann das Zustellelement in radialer Richtung zur z-Achse der NMR-Apparatur ein- und ausgefahren werden.

Die Betätigungskraft auf das Zustellelement ist geringer, da es nur in axialer Richtung hält. Weiterhin ist es unabhängig vom Staudruck wegen des Formschlusses.

Eine vierte Gruppe von Ausführungsformen schließlich zeichnet sich dadurch aus, dass die Haltevorrichtung pneumatisch betätigbare, insbesondere aufblasbare, Elemente umfasst, die das Probenröhrchen in seiner Messposition mit radialem Druck beaufschlagen können.

Diese Variante kommt im Prinzip ohne bewegte Teile aus. Der Ballon verklemmt das Proberöhrchen selbst. Im Vergleich zu den oben genannten Varianten sind nur sehr wenige Bauteile erforderlich.

Eine besonders einfache Weiterbildung dieser Gruppe von Ausführungsformen ist dadurch gekennzeichnet, dass die Haltevorrichtung hochelastische Schläuche, z.B. aus Silikon oder anderen Elastomeren, umfasst, die wangenartig oder ringförmig um das Probenröhrchen in seiner Messposition angeordnet sind, oder einen radial um den Außenumfang des Probenröhrchens angeordneten aufblasbaren O-Ring.

Vorteilhaft ist hier ein guter Reibungskoeffizient mit Glas. Die Schläuche legen sich gleichmäßig am Röhrchen an. Dadurch ergibt sich eine große Kontaktfläche und eine besonders gute Zentrierung des Probenröhrchens.

In der Regel wird die HF-Spule einfach auf der Außenfläche des zylindrischen Temperierrohrs aufgebracht sein, wo sie kaum zusätzlichen Platz erfordert.

Vorzugsweise wird im erfindungsgemäßen NMR-Spektrometer mindestens eine Shimspule zur Erzeugung eines H0-Felds vorhanden sein, welche die HF-Spule mit radialem Abstand umgibt und temperiert ist, insbesondere mit einem eigenen Temperiersystem.

In den Rahmen der vorliegenden Erfindung fällt auch ein Verfahren zum Betrieb eines erfindungsgemäßen NMR-Spektrometers mit einem Probenwechsler der oben beschriebenen Art, gekennzeichnet durch folgende Schritte:

(a) Überführen der Haltevorrichtung in die erste Betriebsstellung;

(b) Einführen eines Probenröhrchens mit einer NMR-Messprobe durch die Bohrung auf seine Messposition im Messvolumen;

(c) Erfassen der Präsenz des Probenröhrchens in der Messposition mittels des ersten Sensorelements;

(d) Fixieren des Probenröhrchens mit Hilfe der Haltevorrichtung;

(e) Überprüfen des aktuellen Vorliegens der zweiten Betriebsstellung der Haltevorrichtung mit Hilfe des weiteren Sensorelements;

(f) Freigabe eines Temperiergas-Stroms zur Temperierung der NMR-Messprobe;

(g) Durchführen einer NMR-Messung an der NMR-Messprobe;

(h) Überführen der Haltevorrichtung in die dritte Betriebsstellung und Herausnehmen des Probenröhrchens aus dem Spektrometer.

Dies erlaubt eine fehlerfreie und sichere Automatisierung ohne Beisein von Mess-Personal. Die Nachvollziehbarkeit der Messungen ist gegeben, da durch die Positionier-Sensorik und die korrekte Temperierung identische Messbedingungen für jedes Sample in einer Messreihe möglich sind. Das ist wesentlich für Messungen bei zertifizierten Verfahren (GXP) und verhindert Fehlmanipulationen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert.

Es zeigen:

Fig. 1      eine schematische Vertikalschnittansicht einer Ausführungsform des erfindungsgemäßen NMR-Spektrometers;

Fig. 2a    einen schematischen Vertikalschnitt durch den unteren Teilbereich des Probenröhrchens im Temperierrohr zur Veranschaulichung des Staudrucks und der erfindungsgemäßen Bedingung $F_f > F_{Stau} - F_{Gewicht}$;

Fig. 2b einen schematischen Vertikalschnitt durch das -verkürzt dargestellte- Probenröhrchen im Temperierrohr zur Veranschaulichung der radialen Klemmung des Probenröhrchens an einer Kontaktfläche der Haltevorrichtung aufgrund von Gleitreibung;

Fig. 3a einen Vertikalschnitt durch den oberen Teilbereich des Probenröhrchens im Temperierrohr mit einer Ausführungsform der erfindungsgemäßen Haltevorrichtung mit Haltekolben, Rückstellfeder und Haltestift;

Fig. 3b wie Fig. 3a, jedoch ohne Probenröhrchen zur Sichtbarmachung des ersten und weiteren Sensorelements;

Fig. 4a wie Fig. 3b, jedoch mit weniger Details sowie mit dem Haltekolben in eingefahrener Betriebsstellung zum Durchlass eines Probenröhrchens;

Fig. 4b wie Fig. 4a, jedoch mit weniger Details und mit dem Haltekolben in ausgefahrener Betriebsstellung zum Halten eines -hier nicht dargestellten- Probenröhrchens im Temperierrohr;

Fig. 5 einen Vertikalschnitt durch den oberen Teilbereich des Temperierrohrs ohne eingeführtes Probenröhrchen mit einer Ausführungsform der Haltevorrichtung, die hier einen pneumatisch aufblasbaren O-Ring umfasst;

Fig. 6a einen schematischen Vertikalschnitt durch das -verkürzt dargestellte- Probenröhrchen im Temperierrohr mit einer weiteren Ausführungsform der Haltevorrichtung mit aufblasbarem O-Ring, hier im nicht-aufgeblasenen Betriebszustand zum Durchlass des Probenröhrchens;

Fig. 6b wie Fig. 6a, jedoch mit dem O-Ring im aufgeblasenen Betriebszustand zum Halten des Probenröhrchens im Temperierrohr; und

Fig. 7 wie Fig. 1, jedoch mit dem erfindungsgemäßen NMR-Spektrometer sowie einem Probenwechsler und einem Robotergreifarm als Bestandteile eines Automatensystems.

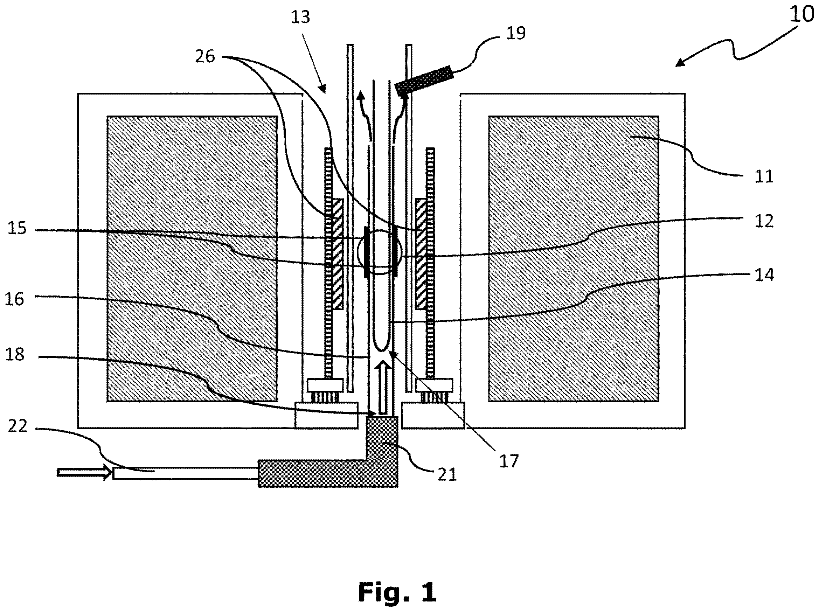

Die Figuren 1 bis 7 der Zeichnung zeigen jeweils in schematischen Ansichten in unterschiedlichem Detail bevorzugte Ausführungsformen des erfindungsgemäßen **NMR-Spektrometers 10.**

Ein derartiges NMR-Spektrometer 10 umfasst eine **Permanentmagnetanordnung 11** zur Erzeugung eines $B_0$ Feldes in einem **Messvolumen 12** mit einer **Bohrung 13** durch das Magnetzentrum zum Einführen einer NMR-Messprobe in einem im Wesentlichen zylindrischen, zumindest an seiner Unterseite geschlossenen **Probenröhrchen 14,** mit einem **Shimsystem 26** sowie mit einer **HF-Spule 15** zur Anregung der Kernspins in der NMR-Messprobe, wobei die HF-Spule 15 außerhalb eines zylindrischen **Temperierrohrs 16** angeordnet ist, welches durch das Messvolumen 12 verläuft und in welches das Probenröhrchen 14 für eine NMR-Messung derart eingebracht werden kann, dass zwischen dem Innenumfang des zylindrischen Temperierrohrs 16 und dem Außenumfang des Probenröhrchens 14 ein durchgängiger **ringförmiger Luftspalt 17** besteht, durch welchen zumindest im NMR-Messbetrieb aus einem Temperiersystem durch einen **Gaseinlass 18** Temperiergas zum Temperieren der NMR-Messprobe im Probenröhrchen 14 geleitet werden kann. Eine **Fluid-Leitung 22** zum Gaseinlass 18 führt das Temperiergas durch einen **Dewar 21.** Das Temperiergas wird von einer -in der Zeichnung nicht eigens dargestellten- Pumpeneinrichtung des NMR-Spektrometers 10 angetrieben.

Die vorliegende Erfindung verbessert diese an sich bekannten NMR-Apparatur und erweitert sie um erfindungswesentlichen Elemente:

Das erfindungsgemäße NMR-Spektrometer 10 zeichnet sich dadurch aus, dass an dem im NMR-Messbetrieb dem Gaseinlass 18 gegenüberliegenden Ende des Probenröhrchens 14 eine relativ zum Probenröhrchen 14 in dessen Messposition bewegliche **Haltevorrichtung 19** im NMR-Spektrometer 10 installiert ist, dass die Haltevorrichtung 19 so ausgestaltet ist, dass sie in einer ersten Betriebsstellung das Probenröhrchen 14 nicht berührt, um dessen Einführung in seine Messposition im NMR-Spektrometer 10 zu ermöglichen, dass sie in einer zweiten Betriebsstellung das Probenröhrchen 14 für die Durchführung der NMR-Messung an seinem Außenumfang kraftschlüssig und/oder formschlüssig mit einer axial auf das Probenröhrchen 14 wirkenden Kraft bzw. Haftreibung $F_f$ in seiner Messposition hält, und dass sie in einer dritten Betriebsstellung das Probenröhrchen 14 zur Entnahme aus dem NMR-Spektrometer 10 wieder freigibt, und dass die Haltevorrichtung 19 so ausgestaltet ist, dass in der zweiten Betriebsstellung gilt

$$F_f > F_{Stau} - F_{Gewicht},$$

wobei $F_{Stau}$ die vom Staudruck des im NMR-Messbetrieb auf das Probenröhrchen 14 strömenden Temperiergases erzeugte Auftriebskraft auf das Probenröhrchen 14 und $F_{Gewicht}$ die Gewichtskraft des Probenröhrchens 14 bedeuten.

Eine erste, besonders einfache Ausführungsform der Erfindung ist stark schematisiert in **Fig. 1** dargestellt:

Eine sichere räumliche Fixierung des Probenröhrchens 14 während der NMR-Messung wird mit dem speziell dafür entwickelten und nach den erfindungsgemäßen Grundsätzen designten beweglichen Element einer Haltevorrichtung 19 erreicht. Vorzugsweise erfolgt die Fixierung am oberen Ende des Probenröhrchens 14, jedenfalls nicht im Messbereich, also nicht im Messvolumen 12. Die Haltevorrichtung 19 umfasst also ein bewegliches Element, das in den Samplekanal ein- und ausgefahren werden kann, durch welchen Probenröhrchen 14 zur NMR-Messung in das Messvolumen 12 eingebracht und daraus danach wieder entfernt werden. Falls sich ein Probenröhrchen 14 im Probenkopf des NMR-Spektrometers 10 befindet, wird durch das Einfahren des beweglichen Elements das Probenröhrchen 14 geklemmt und somit in seiner Mess-Position gehalten.

Eine genügend große Haltekraft wird durch eine entsprechende Einfahrkraft des beweglichen Elements und einer Reibfläche (mit einem möglichst hohen Haftreibungskoeffizient) erreicht.

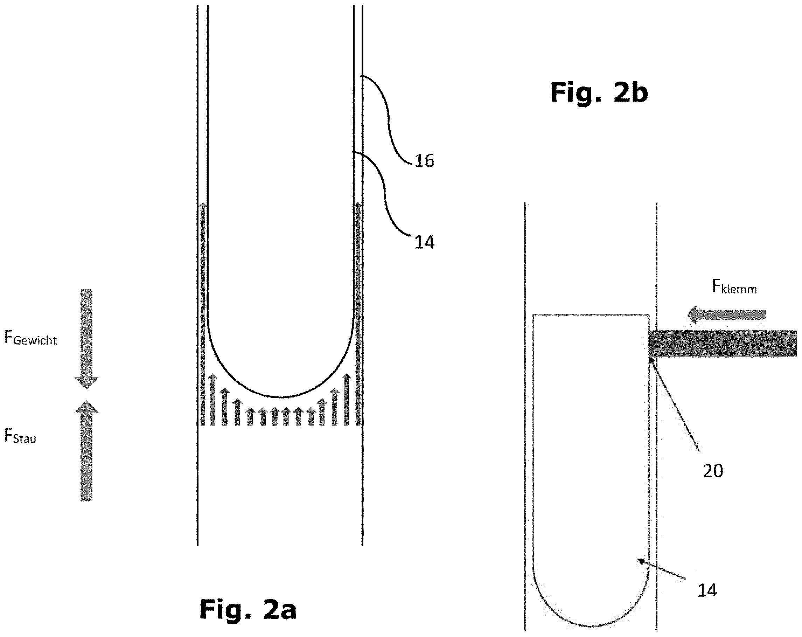

**Fig. 2a** zeigt in einem stark schematisierten Vertikalschnitt durch den unteren Teilbereich des Probenröhrchens 14 im Temperierrohr 16 das von unten auf das Probenröhrchen 14 einströmende Temperiergas. Dieses bewirkt entsprechend am Probenröhrchen 14 einen Staudruck. Damit aber das Probenröhrchen 14 während der NMR-Messung durch diesen permanent anstehenden Staudruck nicht nach oben aus dem Messvolumen 12 herausgepresst wird, darf bei NMR-Spektrometern nach dem Stand der Technik die Gewichtskraft $F_{Gewicht}$ des Probenröhrchens 14 nicht kleiner sein als die durch den Staudruck auf das Probenröhrchen 14 von unten her einwirkende Druckkraft Fstau. Andererseits darf jedoch die Gewichtskraft $F_{Gewicht}$ auch nicht größer sein als die Druckkraft $F_{Stau}$, weil sonst jedenfalls ohne weitere Maßnahmen- das Probenröhrchen 14 nach unten aus dem Messvolumen 12 herausfallen würde. Im Stand der Technik wird daher in der Regel der Staudruck durch Einstellung des Volumenstroms des Temperiergases gerade so eingeregelt, dass das Probenröhrchen 14 in seiner Mess-Position gerade in der Schwebe gehalten wird, also $F_{Stau} \approx F_{Gewicht}$. Damit entfällt aber dann wiederum der Parameter des Temperiergas-Volumenstroms für eine Optimierung der Temperierung des Probenröhrchens 14.

Durch die erfindungsgemäße Ausgestaltung der neuartigen Haltevorrichtung 19 hingegen kann unter Einhaltung der erfindungsgemäß vorgeschriebenen Bedingung $F_f > F_{Stau} - F_{Gewicht}$ für die auf das Probenröhrchen 14 wirkende Haltekraft bzw. Haftreibung $F_f$ der wichtige Prozessparameter des Temperiergas-Volumenstroms in weiten Grenzen variiert werden, um die Temperierung des Probenröhrchens 14 zu optimieren. Dadurch kann nunmehr in der Praxis der Volumenstrom des Temperiergases während des NMR-Messbetriebs des NMR-Spektrometers 10 in einem breiten Bereich zwischen etwa 1 l/min und bis zu 20 l/min, vorzugsweise zwischen 3,5 l/min und 12 l/min frei eingestellt werden.

Die radiale Öffnungsbreite des durchgängigen ringförmigen Luftspalts 17 zwischen dem Innenumfang des zylindrischen Temperierrohrs 16 und dem Außenumfang des Probenröhrchens 14 in der Messposition des Probenröhrchens 14 wird beim erfindungsgemäßen NMR-Spektrometer 10 in der Regel zwischen 0,1mm und 1mm, vorzugsweise zwischen 0,15mm und 0,3mm gewählt.

**Fig. 2b** veranschaulicht in einem wiederum stark schematisierten Vertikalschnitt durch das -hier verkürzt dargestellte- Probenröhrchen 14 im Temperierrohr 16 die radiale Klemmung des Probenröhrchens 14 an einer **Kontaktfläche 20** der Haltevorrichtung 19 aufgrund von Gleitreibung. Dabei wirkt eine Klemmkraft $F_{klemm}$ radial auf das Probenröhrchen 14 ein. Bei einem Reibungskoeffizienten $\mu$ muss daher für die erfindungsgemäße Anordnung gelten:

$$F_f = \mu * F_{klemm}.$$

Die erfindungsgemäße Haltevorrichtung 19 ist vorzugsweise so gestaltet, dass die Kontaktfläche 20 zwischen dem Probenröhrchen 14 und der Haltevorrichtung 19 einen Reibungskoeffizienten $\mu > 0,3$ aufweist.

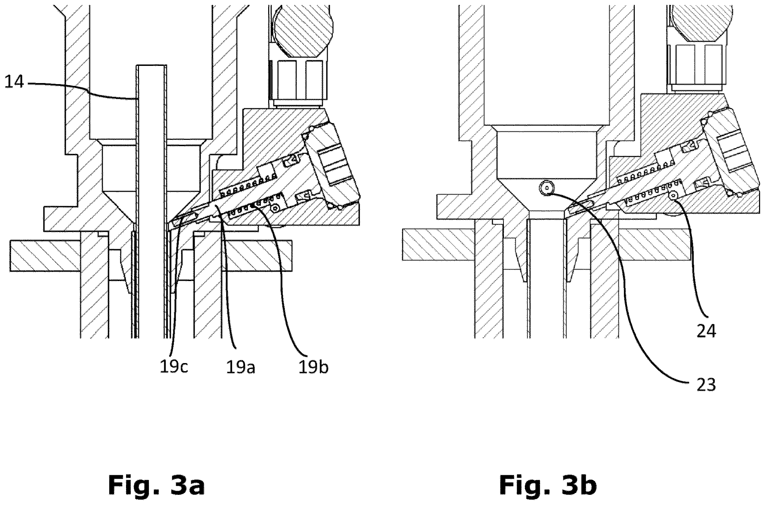

In **Fig. 3a** ist eine weitere Ausgestaltung der erfindungsgemäßen Haltevorrichtung 19 in einem Vertikalschnitt durch den oberen Teilbereich des Probenröhrchens 14 im Temperierrohr 16 dargestellt. Diese Ausführungsform der erfindungsgemäßen Haltevorrichtung 19 umfasst einen **Haltekolben 19a,** eine **Rückstellfeder 19b** und einen **Haltestift 19c.**

Der Haltekolben 19a kann mittels Druckluft oder auch Motorgetrieben mit einer Kraft beaufschlagt werden, die den Kolben entgegen der Federkraft der Rückstellfeder 19b gegen das Probenröhrchen 14 schiebt und mit dem Haltestift 19c dagegen drückt.

Um die korrekte Positionierung des Probenröhrchen 14 im Messraum zu detektieren, ist ein **erstes Sensorelement 23** zur Bestimmung der Anwesenheit des Probenröhrchens 14 innerhalb des NMR-Spektrometers 10 vorhanden, wie in **Fig. 3b** zu erkennen. Fig. 3b zeigt denselben Ausschnitt aus der NMR-Apparatur wie Fig. 3a, jedoch ohne das Probenröhrchen zur besseren Sichtbarmachung der Sensorelemente. Vorzugsweise ist der erste Sensor derart angebracht, dass die Beladungssituation mit dem Probenröhrchen 14 sicher und zweifelsfrei festgestellt werden kann. Beispielsweise kann der Sensor eine Lichtschranke umfassen.

Ein **weiteres Sensorelement 24** zur Bestimmung der aktuellen Betriebsstellung der Haltevorrichtung 19 ist ebenfalls in Fig. 3b abgebildet. Dieser zweite Sensor zeigt an, wenn der Haltestift 19c vollständig ausgefahren ist und sich in derjenigen Betriebsposition befindet, in welcher er gegen das Probenröhrchen 14 drückt und selbiges durch Festklemmen in Position hält. Erst wenn dieser Positioniernachweis durch den zweiten Sensor angezeigt wird, kann der AT-Gasfluss freigegeben werden, da ansonsten das Probenröhrchen 14 nicht korrekt positionierbar ist.

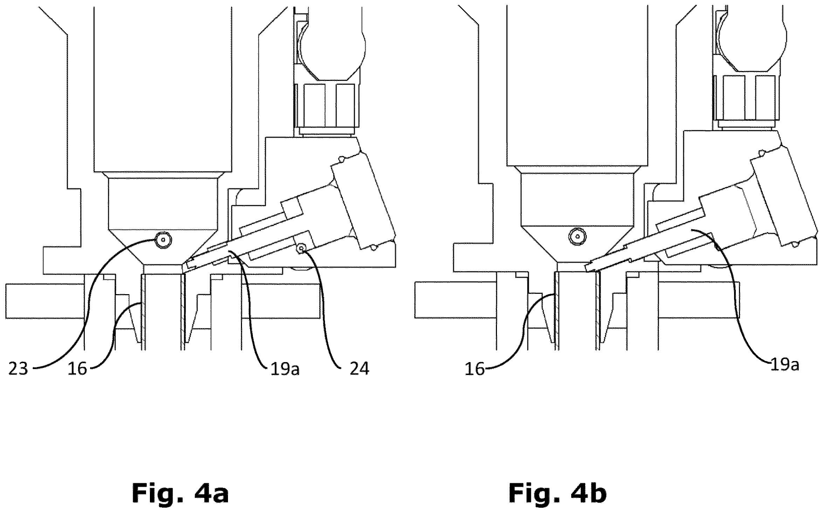

In Fig. 4a ist dieselbe Situation wie Fig. 3b dargestellt, jedoch mit weniger Details sowie mit dem Haltekolben 19a in eingefahrener Betriebsstellung zum Durchlass eines -hier wiederum nicht abgebildeten- Probenröhrchens 14.

Fig. 4b zeigt die gleichen Apparatur-Komponenten wie Fig. 4a, jedoch mit dem Haltekolben 19a in ausgefahrener Betriebsstellung zum Halten eines -aus Gründen der besseren Sichtbarkeit hier wiederum nicht dargestellten-Probenröhrchens 14 im Temperierrohr 16.

Bei einer -in der Zeichnung nicht dargestellten- Gruppe von weiteren Ausführungsformen der Erfindung kann die Haltevorrichtung 19 Haltewangen umfasst, die zumindest Teile des Außenumfangs des Probenröhrchens 14 zangenartig festklemmen können, wobei die Haltewangen vorzugsweise als Spannzange oder als zwei Halbschalen ausgebildet sind, die das Probenröhrchen 14 an seinem Außenumfang von beiden Seiten festhalten können.

Vorteilhaft bei diesen Ausführungen der Haltevorrichtung ist, dass das Probenröhrchen 14 besser zentriert in der Mitte des Spulenglases gehalten werden kann. Jedoch benötigt eine Mechanik für Zangen etwas mehr Bauraum.

Bei einer weiteren Gruppe von nicht gezeigten Ausführungsformen umfasst die Haltevorrichtung 19 eine Irisblende.

Des Weiteren kann die Haltevorrichtung 19 auch ein Zustellelement aufweisen, welches in der zweiten Betriebsstellung Deckel-artig über dem dem Gaseinlass 18 gegenüberliegenden Ende des Probenröhrchens 14 in axialer Richtung das Probenröhrchen 14 von einer Bewegung aus der Messposition abhält.

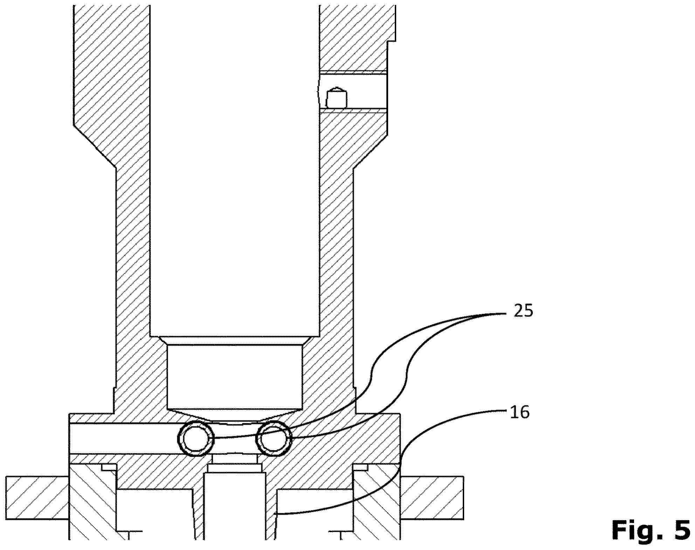

In einer weiteren Gruppe von alternativen Ausgestaltungen kann -wie in Fig. 5 in einem Vertikalschnitt durch den oberen Teilbereich des Temperierrohrs 16 ohne eingeführtes Probenröhrchen 14 gezeigt- die Haltevorrichtung 19 pneumatisch betätigbare Elemente 25 umfassen, die insbesondere aufblasbar sein können und das Probenröhrchen 14 in seiner Messposition mit radialem Druck beaufschlagen.

Das Halteelement ist als Schlauch (hier konkret als pneumatisch aufblasbarer O-Ring) ausgebildet, der um das Probenröhrchen herumgeführt ist. Für die Klemmung wird der Schlauch mit Druckluft beaufschlagt. Dadurch dehnt sich der Schlauch aus und fixiert das Probenröhrchen in seiner Mess-Position.

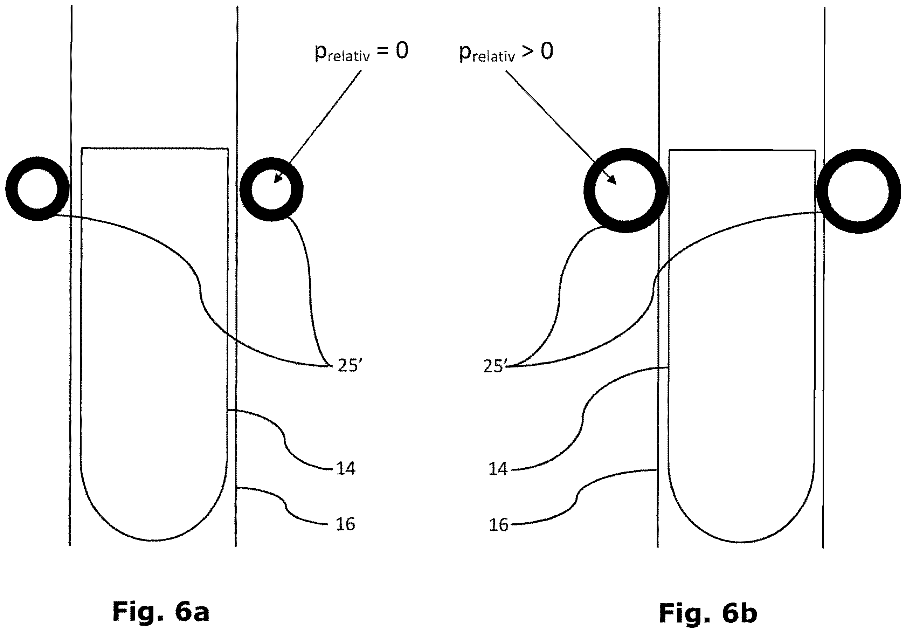

Die Figuren 6a und 6b zeigen jeweils einen schematischen Vertikalschnitt durch das -hier verkürzt dargestellte- Probenröhrchen 14 im Temperierrohr 16 mit einer weiteren Ausführungsform der erfindungsgemäßen Haltevorrichtung mit aufblasbarem O-Ring 25', hier im nicht-aufgeblasenen Betriebszustand zum Durchlass des Probenröhrchens

Fig. 6a stellt das pneumatisch betätigbare Element 25' im nicht-aufgeblasenen Betriebszustand zum Durchlass des Probenröhrchens 14 dar, während in Fig. 6b der O-Ring 25' im aufgeblasenen Betriebszustand zum Halten des Probenröhrchens 14 im Temperierrohr 16 gezeigt ist. Der aufblasbare Schlauch ist also in Fig. 6a ohne Druckluftbeaufschlagung gegenüber dem Umgebungsdruck ($p_{relativ}$ = 0) und in Fig. 6b mit Druckluftbeaufschlagung ($p_{relativ}$ > 0) zu sehen. Durch das Aufdehnen des Schlauchs, der ringförmig um das Probenröhrchen 14 herum angeordnet ist, wird eine Haltekraft am Probenröhrchen 14 erzeugt, die das NMR-Röhrchen ortsfest im AT-Temperierstrom hält.

Bei allen oben vorgestellten Varianten der Erfindung kann die Haltevorrichtung 19 manuell, mechanisch elektrisch, magnetisch oder pneumatisch angetrieben werden.

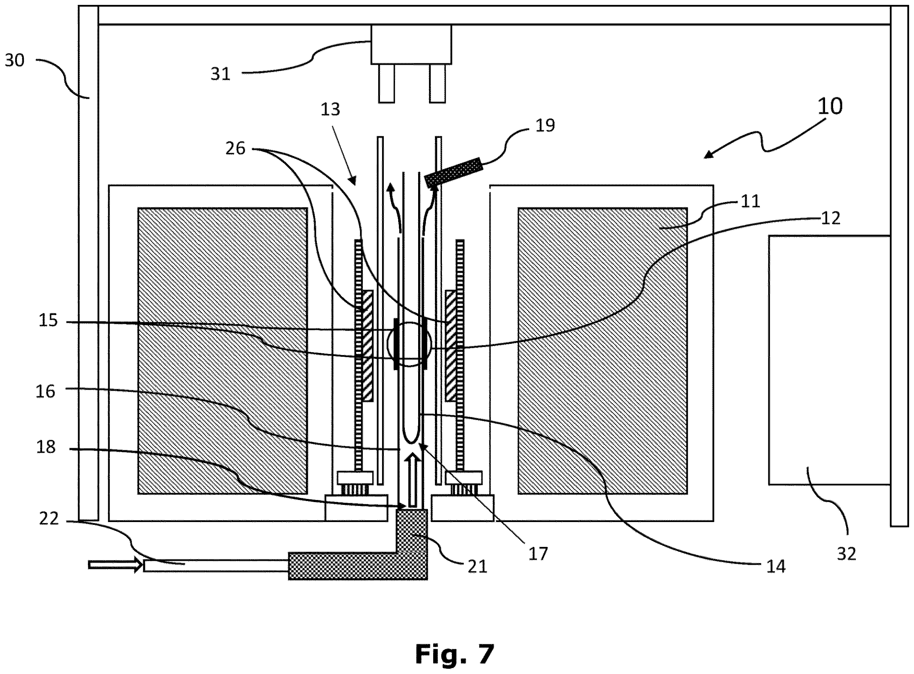

Fig. 7 schließlich zeigt (zusätzlich zu Fig. 1) einen Probenwechsler 32 zum automatisierten Beschicken des NMR-Spektrometers 10 mit Probenröhrchen 14, welcher ein Vorratsbehältnis zur Bevorratung einer Mehrzahl von Probenröhrchen sowie eine Vorrichtung zur Übergabe und Herausnahme der Proberöhrchen 14 in das Messvolumen 12 bzw. aus dem Messvolumen 12 umfasst. Ein Probenwechsler im Sinne der vorliegenden Erfindung ist normalerweise an der Oberseite des NMR-Spektrometers 10 angeordnet und dazu ausgestattet, das Spektrometer mit unterschiedlichen NMR-Röhrchen aus einem Vorratsbehältnis zu beschicken und diese nach der Messung wieder aus dem Messvolumen 12 zu entfernen.

Im dargestellten Ausführungsbeispiel wirkt die Haltevorrichtung 19 gleichzeitig als Vorrichtung zur Übergabe und Herausnahme von Proberöhrchen 14. Das NMR-Spektrometer 10 sowie der Probenwechsler 32 sind hier Bestandteile eines Automatensystems 30 mit Robotergreifarm 31.

Die Merkmale aller oben beschriebenen Ausführungsformen der Erfindung können jedenfalls -größtenteils- auch miteinander kombiniert werden.

**Referenzliste:**

Für die Beurteilung der Patentfähigkeit in Betracht gezogene Druckschriften

[1] DE 10 2019 212 508 A1
[2] DE 10 2004 029 633 B4
[3] DE 10 2018 205 535 B3 ≈ EP 3 561 533 B1 ≈ US 10,782,369 B2
[4] EP 3 715 893 B1 ≈ ZL 2020 1 0210645.3 ≈ US 11,073,583 B2
[5] US 10,436,859 B2
[6] EP 3 561 533 B1
[7] DE 10 2016 203891 A1

**Bezugszeichenliste:**

| 10 | NMR-Spektrometer |
| 11 | Permanentmagnetvorrichtung |
| 12 | Messvolumen |
| 13 | Magnet-Bohrung |
| 14 | Probenröhrchen |
| 15 | HF-Spule |
| 16 | Temperierrohr |
| 17 | ringförmiger Luftspalt |
| 18 | Gaseinlass |
| 19 | Haltevorrichtung |
| 19a | Haltekolben |
| 19b | Rückstellfeder |
| 19c | Haltestift |
| 20 | Kontaktfläche |
| 21 | Dewar |
| 22 | Leitung zum Gaseinlass |
| 23 | erstes Sensorelement |
| 24 | weiteres Sensorelement |
| 25; 25' | pneumatisch betätigbare Elemente |
| 26 | Shimsystem |
| 30 | Automatensystem |
| 31 | Robotergreifarm |
| 32 | Probenwechsler |

**Patentansprüche**

1. NMR-Spektrometer (10) mit einem NMR-Magnetsystem, welches eine Permanentmagnetvorrichtung (11) zur Erzeugung eines $B_0$ Feldes in einem Messvolumen (12) sowie eine Bohrung (13) durch das Magnetzentrum zum Einführen einer NMR-Messprobe in einem im Wesentlichen zylindrischen, zumindest an seiner Unterseite geschlossenen Probenröhrchen (14) aufweist, sowie mit einer HF-Spule (15) zur Anregung der Kernspins in der NMR-Messprobe und mit einem Temperiersystem, wobei die HF-Spule (15) außerhalb eines zylindrischen Temperierrohrs (16) angeordnet ist, welches durch das Messvolumen (12) verläuft und in welches das Probenröhrchen (14) für eine NMR-Messung derart eingebracht werden kann, dass zwischen dem Innenumfang des zylindrischen Temperierrohrs (16) und dem Außenumfang des Probenröhrchens (14) ein durchgängiger ringförmiger Luftspalt (17) besteht, durch welchen zumindest im NMR-Messbetrieb aus dem Temperiersystem durch einen Gaseinlass (18) Temperiergas zum Temperieren der NMR-Messprobe im Probenröhrchen (14) geleitet werden kann, **dadurch gekennzeichnet,**

dass an dem im NMR-Messbetrieb dem Gaseinlass (18) gegenüberliegenden Ende des Probenröhrchens (14) eine relativ zum Probenröhrchen (14) in dessen Messposition bewegliche Haltevorrichtung (19) im NMR-Spektrometer (10) installiert ist,
**dass** die Haltevorrichtung (19) so ausgestaltet ist, dass sie in einer ersten Betriebsstellung das Probenröhrchen (14) nicht berührt, um dessen Einführung in seine Messposition im NMR-Spektrometer (10) zu ermöglichen, dass sie in einer zweiten Betriebsstellung das Probenröhrchen (14) für die Durchführung der NMR-Messung an seinem Außenumfang kraftschlüssig und/oder formschlüssig mit einer axial auf das Probenröhrchen (14) wirkenden Kraft bzw. Haftreibung $F_f$ in seiner Messposition hält, und dass sie in einer dritten Betriebsstellung das Probenröhrchen (14) zur Entnahme aus dem NMR-Spektrometer (10) wieder freigibt,
und **dass** die Haltevorrichtung (19) so ausgestaltet ist, dass in der zweiten Betriebsstellung gilt

$$F_f > F_{Stau} - F_{Gewicht},$$

wobei $F_{Stau}$ die vom Staudruck des im NMR-Messbetrieb auf das Probenröhrchen (14) strömenden Temperiergases erzeugte Auftriebskraft auf das Probenröhrchen (14) und $F_{Gewicht}$ die Gewichtskraft des Probenröhrchens (14) bedeuten.

2. NMR-Spektrometer nach Anspruch 1, **dadurch gekennzeichnet, dass** die Haltevorrichtung (19) so gestaltet ist, dass eine Kontaktfläche (20) zwischen dem Probenröhrchen (14) und der Haltevorrichtung (19) einen Reibungskoeffizienten $\mu > 0{,}3$ aufweist, und dass gilt

$$F_f = \mu * F_{klemm},$$

wobei $F_{klemm}$ die radial auf das Probenröhrchen (14) wirkende Klemmkraft und $\mu$ der Reibungskoeffizient sind.

3. NMR-Spektrometer nach einem der vorhergehenden Ansprüche, **dadurch gekennzeichnet, dass** der durchgängige ringförmige Luftspalt (17) zwischen dem Innenumfang des zylindrischen Temperierrohrs (16) und dem Außenumfang des Probenröhrchens (14) in der Messposition des Probenröhrchens (14) eine radiale Öffnungsbreite zwischen 0,1 mm und 1mm, vorzugsweise zwischen 0,15mm und 0,3mm aufweist.

4. NMR-Spektrometer nach einem der vorhergehenden Ansprüche, **dadurch gekennzeichnet, dass** das Temperiergas einen Volumenstrom von mindestens 1 l/min und maximal 20 l/min, vorzugsweise 3,5 l/min bis 12 l/min, während des NMR-Messbetriebs des NMR-Spektrometers (10) aufweist.

5. NMR-Spektrometer nach einem der vorhergehenden Ansprüche, **dadurch gekennzeichnet, dass** ein Probenwechsler (32) zum automatisierten Beschicken des NMR-Spektrometers (10) mit Probenröhrchen (14) vorhanden ist, welcher ein Vorratsbehältnis zur Bevorratung einer Mehrzahl von Probenröhrchen (14) und eine Vorrichtung zur Übergabe und Herausnahme der Proberöhrchen (14) in das Messvolumen (12) bzw. aus dem Messvolumen (12) umfasst.

6. NMR-Spektrometer nach Anspruch 5, **dadurch gekennzeichnet, dass** die Haltevorrichtung (19) gleichzeitig als Vorrichtung zur Übergabe und Herausnahme von Proberöhrchen (14) wirkt, und dass das NMR-Spektrometers (10) sowie der Probenwechsler (32) vorzugsweise Bestandteile eines Automatensystems (30) mit Robotergreifarm (31) sind.

7. NMR-Spektrometer nach einem der vorhergehenden Ansprüche, **dadurch gekennzeichnet, dass** ein Dewar (21) vorhanden ist, welcher eine vom Temperiersystem zum Gaseinlass (18) führende Leitung (22) zumindest teilweise umgibt.

8. NMR-Spektrometer nach einem der vorhergehenden Ansprüche, **dadurch gekennzeichnet, dass** ein erstes Sensorelement (23) zur Bestimmung der Anwesenheit des Probenröhrchen (14) innerhalb des NMR-Spektrometers (10) vorhanden ist.

9. NMR-Spektrometer nach Anspruch 8, **dadurch gekennzeichnet, dass** ein weiteres Sensorelement (24) zur Bestimmung der aktuellen Betriebsstellung der Haltevorrichtung (19) vorhanden ist.

10. NMR-Spektrometer nach einem der Ansprüche 1 bis 5 und 7 bis 9, **dadurch gekennzeichnet, dass** die Haltevorrichtung (19) einen Haltekolben (19a) umfasst, der mittels Druckluft oder auch Motorgetrieben mit einer Kraft beaufschlagt werden kann, die dann den Haltekolben (19a) entgegen einer Rückstellkraft, insbesondere der Federkraft einer Rückstellfeder (19b) gegen das Probenröhrchen (14) verschiebt.

11. NMR-Spektrometer nach einem der Ansprüche 1 bis 10, **dadurch gekennzeichnet, dass** die Haltevorrichtung (19) Haltewangen umfasst, die zumindest Teile des Außenumfangs des Probenröhrchens (14) zangenartig festklemmen können, wobei die Haltewangen vorzugsweise als Spannzange oder als zwei Halbschalen ausgebildet sind, die das Probenröhrchen (14) an seinem Außenumfang von beiden Seiten festhalten können.

12. NMR-Spektrometer nach einem der Ansprüche 1 bis 9, **dadurch gekennzeichnet, dass** die Haltevorrichtung (19) eine Irisblende umfasst.

13. NMR-Spektrometer nach einem der Ansprüche 1 bis 5 und 7 bis 9, **dadurch gekennzeichnet, dass** die Haltevorrichtung (19) ein Zustellelement aufweist, welches in der zweiten Betriebsstellung Deckel-artig über dem dem Gaseinlass (18) gegenüberliegenden Ende des Probenröhrchens (14) in axialer Richtung das Probenröhrchen (14) von einer Bewegung aus der Messposition abhält.

14. NMR-Spektrometer nach einem der Ansprüche 1 bis 9, **dadurch gekennzeichnet, dass** die Haltevorrichtung (19) pneumatisch betätigbare, insbesondere aufblasbare, Elemente (25; 25') umfasst, die das Probenröhrchen (14) in seiner Messposition mit radialem Druck beaufschlagen können.

15. Verfahren zum Betrieb eines NMR-Spektrometers (10) nach einem der Ansprüche 9 bis 14 mit einem Probenwechsler (32) nach Anspruch 5, **gekennzeichnet durch** folgende Schritte:

    (a) Überführen der Haltevorrichtung (19) in die erste Betriebsstellung;
    (b) Einführen eines Probenröhrchens (14) mit einer NMR-Messprobe durch die Bohrung (13) auf seine Messposition im Messvolumen (12);
    (c) Erfassen der Präsenz des Probenröhrchens (14) in der Messposition mittels des ersten Sensorelements (23);
    (d) Fixieren des Probenröhrchens (14) mit Hilfe der Haltevorrichtung (19);
    (e) Überprüfen des aktuellen Vorliegens der zweiten Betriebsstellung der Haltevorrichtung (19) mit Hilfe des weiteren Sensorelements (24);
    (f) Freigabe eines Temperiergas-Stroms zur Temperierung der NMR-Messprobe;
    (g) Durchführen einer NMR-Messung an der NMR-Messprobe;
    (h) Überführen der Haltevorrichtung (19) in die dritte Betriebsstellung und Herausnehmen des Probenröhrchens (14) aus dem Spektrometer (10).

**Claims**

1. NMR spectrometer (10) having an NMR magnet system, which comprises a permanent magnet device (11) for generating a $B_0$ field in a measuring volume (12), and a bore (13) through the magnet center for introducing an NMR measurement sample in a substantially cylindrical sample tube (14), closed at least on its underside, and having an RF coil (15) for exciting the nuclear spins in the NMR measurement sample and having a temperature control system, the RF coil (15) being arranged outside a cylindrical temperature control tube (16) which extends through the measuring volume (12) and into which the sample tube (14) can be introduced for an NMR measurement in such a way that between the inner circumference of the cylindrical temperature control tube (16) and the outer circumference of the sample tube (14) there is a continuous annular air gap (17), through which, at least in NMR measuring operation, temperature control gas for controlling the temperature of the NMR measurement sample in the sample tube (14) can be guided from the temperature control system through a gas inlet (18), **characterized in that**

a holding device (19), which is movable relative to the sample tube (14) in the measuring position thereof, is installed in the NMR spectrometer (10) at the end of the sample tube (14) opposite the gas inlet (18) during NMR measuring operation,

**in that** the holding device (19) is designed in such a way that, in a first operating position, it does not touch the sample tube (14), in order to enable its introduction into its measuring position in the NMR spectrometer (10),

**in that**, in a second operating position, it holds the sample tube (14) for carrying out the NMR measurement in the measuring position thereof on its outer circumference in a force-locking and/or form-locking manner with a force or static friction $F_f$ acting axially on the sample tube (14), and **in that**, in a third operating position, it releases the sample tube (14) again for removal from the NMR spectrometer (10),

and **in that** the holding device (19) is designed in such a way that in the second operating position,

$$F_f > F_{Stau} - F_{Gewicht},$$

where $F_{Stau}$ is the buoyancy force on the sample tube (14) generated by the dynamic pressure of the temperature control gas flowing onto the sample tube (14) during NMR measurement operation and $F_{Gewicht}$ is the weight of the sample tube (14).

2. NMR spectrometer according to claim 1, **characterized in that** the holding device (19) is designed in such a way that a contact surface (20) between the sample tube (14) and the holding device (19) has a friction coefficient of $\mu > 0.3$, and **in that**

$$F_f = \mu * F_{klemm},$$

where $F_{klemm}$ is the clamping force acting radially on the sample tube (14) and $\mu$ is the friction coefficient.

3. NMR spectrometer according to either of the preceding claims, **characterized in that** the continuous annular air gap (17) between the inner circumference of the cylindrical temperature control tube (16) and the outer circumference of the sample tube (14) in the measuring position of the sample tube (14) has a radial opening width between 0.1 mm and 1 mm, preferably between 0.15 mm and 0.3 mm.

4. NMR spectrometer according to any of the preceding claims, **characterized in that** the temperature control gas has a volume flow of at least 1 l/min and at most 20 l/min, preferably 3.5 l/min to 12 l/min, during the NMR measuring operation of the NMR spectrometer (10).

5. NMR spectrometer according to any of the preceding claims, **characterized in that** a sample changer (32) is provided for automatically supplying the NMR spectrometer (10) with sample tubes (14), which sample changer has a storage container for storing a plurality of sample tubes (14) and a device for transferring the sample tubes (14) into the measuring volume (12) and removing them from the measuring volume (12).

6. NMR spectrometer according to claim 5, **characterized in that** the holding device (19) simultaneously acts as a device for transferring and removing sample tubes (14), and **in that** the NMR spectrometer (10) and the sample changer (32) are preferably components of an automated system (30) having a robot gripper arm (31).

7. NMR spectrometer according to any of the preceding claims, **characterized in that** a dewar (21) is present which at least partially surrounds a line (22) leading from the temperature control system to the gas inlet (18).

8. NMR spectrometer according to any of the preceding claims, **characterized in that** a first sensor element (23) for determining the presence of the sample tube (14) is provided within the NMR spectrometer (10).

9. NMR spectrometer according to claim 8, **characterized in that** a further sensor element (24) is provided for determining the current operating position of the holding device (19).

10. NMR spectrometer according to any of claims 1 to 5 and 7 to 9, **characterized in that** the holding device (19) has a holding piston (19a) which can be subjected to a force by means of compressed air or motor drives, which force then moves the holding piston (19a) against the sample tube (14) counter to a restoring force, in particular the spring force of a restoring spring (19b).

11. NMR spectrometer according to any of claims 1 to 10, **characterized in that** the holding device (19) comprises holding cheeks which can clamp at least parts of the outer circumference of the sample tube (14) in a tong-like manner, the holding cheeks preferably being designed as collet chuck or as two half-shells which can hold the sample tube (14) on its outer circumference from both sides.

12. NMR spectrometer according to any of claims 1 to 9, **characterized in that** the holding device (19) has an iris diaphragm.

13. NMR spectrometer according to any of claims 1 to 5 and 7 to 9, **characterized in that** the holding device (19) comprises a blocking element which, in the second operating position, in the manner of a lid over the end of the sample tube (14) opposite the gas inlet (18), prevents the sample tube (14) from moving out of the measuring position in the axial direction.

14. NMR spectrometer according to any of claims 1 to 9, **characterized in that** the holding device (19) has pneumatically actuable, in particular inflatable, elements (25; 25') which can apply radial pressure to the sample tube (14) in its measuring position.

15. Method for operating an NMR spectrometer (10) according to any of claims 9 to 14 having a sample changer (32) according to claim 5, **characterized by** the following steps:

(a) transferring the holding device (19) into the first operating position;
(b) inserting a sample tube (14) having an NMR measurement sample through the bore (13) to its measuring position in the measuring volume (12);
(c) detecting the presence of the sample tube (14) in the measuring position by means of the first sensor element (23);
(d) fixing the sample tube (14) by means of the holding device (19);
(e) checking the current presence of the second operating position of the holding device (19) by means of the further sensor element (24);
(f) releasing a temperature control gas stream for controlling the temperature of the NMR measurement sample;
(g) performing an NMR measurement on the NMR measurement sample;
(h) transferring the holding device (19) to the third operating position and removing the sample tube (14) from the spectrometer (10).

## Revendications

1. Spectromètre RMN (10) comprenant un système magnétique RMN qui présente un dispositif à aimant permanent (11) permettant de générer un champ $B_0$ dans un volume de mesure (12) et présente un alésage (13) réalisé à travers le centre de l'aimant et permettant d'introduire un échantillon de mesure RMN placé dans un tube à échantillon (14) essentiellement cylindrique au moins fermé au niveau de sa face inférieure, et comprenant une bobine HF (15) permettant d'exciter les spins nucléaires dans l'échantillon de mesure RMN et comprenant un système de thermorégulation, la bobine HF (15) étant agencée à l'extérieur d'un tube de thermorégulation cylindrique (16) passant à travers le volume de mesure (12) et au sein duquel le tube à échantillon (14) destiné à une mesure RMN peut être introduit de telle manière qu'un entrefer annulaire continu (17), à travers lequel du gaz de thermorégulation provenant du système de thermorégulation par une entrée de gaz (18) et permettant de réguler la température de l'échantillon de mesure RMN présent dans le tube à échantillon (14) peut être canalisé au moins en cours de fonctionnement de mesure RMN, est constitué entre la périphérie intérieure du tube de thermorégulation cylindrique (16) et la périphérie extérieure du tube à échantillon (14),

**caractérisé en ce que**

un dispositif de retenue (19) mobile par rapport au tube à échantillon (14) dans sa position de mesure est installé dans le spectromètre RMN (10) à l'extrémité du tube à échantillon (14) qui est opposée à l'entrée de gaz (18) en cours de fonctionnement de mesure RMN,
le dispositif de retenue (19) est conçu de sorte que, dans une première position de fonctionnement, il ne touche pas le tube à échantillon (14) afin de permettre son introduction dans sa position de mesure dans le spectromètre RMN (10), de sorte que, dans une deuxième position de fonctionnement, il retient le tube à échantillon (14) dans sa position de mesure au niveau de sa périphérie extérieure par complémentarité de force et/ou par complémentarité de forme avec une force ou un frottement statique $F_f$ agissant axialement sur le tube à échantillon (14), afin d'effectuer la mesure RMN, et de sorte que, dans une troisième position de fonctionnement, il libère le tube à échantillon (14) afin qu'il puisse être retiré du spectromètre RMN (10),

et le dispositif de retenue (19) est conçu de sorte que, dans la deuxième position de fonctionnement,

$$F_f > F_{Stau} - F_{Gewicht},$$

$F_{Stau}$ désignant la force de portance générée par la pression dynamique du gaz de thermorégulation circulant sur le tube à échantillon (14) en cours de fonctionnement de mesure RMN et $F_{Gewicht}$ désignant la force liée au poids du tube à échantillon (14).

2. Spectromètre RMN selon la revendication 1, **caractérisé en ce que** le dispositif de retenue (19) est conçu de sorte qu'une surface de contact (20) entre le tube à échantillon (14) et le dispositif de retenue (19) présente un coefficient de friction $\mu > 0,3$, et que

$$F_f = \mu * F_{klemm},$$

$F_{klemm}$ étant la force de serrage agissant radialement sur le tube à échantillon (14) et $\mu$ étant le coefficient de friction.

3. Spectromètre RMN selon l'une quelconque des revendications précédentes, **caractérisé en ce que** l'entrefer annulaire continu (17) entre la périphérie intérieure du tube de thermorégulation cylindrique (16) et la périphérie extérieure du tube à échantillon (14) présente, dans la position de mesure du tube à échantillon (14), une largeur d'ouverture radiale comprise entre 0,1 mm et 1 mm, de manière préférée comprise entre 0,15 mm et 0,3 mm.

4. Spectromètre RMN selon l'une quelconque des revendications précédentes, **caractérisé en ce que** le gaz de thermorégulation présente un débit volumique d'au moins 1 l/min et d'au plus 20 l/min, de manière préférée compris entre 3,5 l/min et 12 l/min, en cours de fonctionnement de mesure RMN du spectromètre RMN (10).

5. Spectromètre RMN selon l'une quelconque des revendications précédentes, **caractérisé en ce qu'**un passeur d'échantillon (32) est présent, qui permet l'approvisionnement automatique du spectromètre RMN (10) en tubes à échantillon (14) et qui comprend un récipient de stockage permettant de stocker une pluralité de tubes à échantillon (14) et un dispositif permettant de transférer et retirer des tubes à échantillon (14) dans le volume de mesure (12) ou à partir du volume de mesure (12).

6. Spectromètre RMN selon la revendication 5, **caractérisé en ce que** le dispositif de retenue (19) agit simultanément comme dispositif de transfert et de retrait de tubes à échantillon (14), et **en ce que** le spectromètre RMN (10) ainsi que le passeur d'échantillons (32) sont de manière préférée des composants d'un système automatisé (30) comprenant un bras de préhension de robot (31).

7. Spectromètre RMN selon l'une quelconque des revendications précédentes, **caractérisé en ce qu'**un dispositif Dewar (21) est présent, qui entoure au moins partiellement une conduite (22) menant du système de thermorégulation jusqu'à l'entrée de gaz (18).

8. Spectromètre RMN selon l'une quelconque des revendications précédentes, **caractérisé en ce qu'**un premier élément formant capteur (23) est présent afin de déterminer la présence du tube à échantillon (14) à l'intérieur du spectromètre RMN (10).

9. Spectromètre RMN selon la revendication 8, **caractérisé en ce qu'**un élément formant capteur (24) supplémentaire est présent afin de déterminer la position de fonctionnement effective du dispositif de retenue (19).

10. Spectromètre RMN selon l'une quelconque des revendications 1 à 5 et 7 à 9, **caractérisé en ce que** le dispositif de retenue (19) comprend un piston de retenue (19a) qui, au moyen d'air comprimé ou d'engrenages moteurs, peut être soumis à une force qui déplace ensuite le piston de retenue (19a) contre le tube à échantillon (14) à l'encontre d'une force de rappel, en particulier de la force élastique d'un ressort de rappel (19b).

11. Spectromètre RMN selon l'une quelconque des revendications 1 à 10, **caractérisé en ce que** le dispositif de retenue (19) comprend des joues de retenue qui peuvent serrer en tenailles au moins des parties de la périphérie extérieure du tube à échantillon (14), les joues de retenue étant réalisées de manière préférée sous la forme d'une pince de serrage ou de deux demi-coques pouvant maintenir le tube à échantillon (14) des deux côtés au niveau de sa périphérie extérieure.

12. Spectromètre RMN selon l'une quelconque des revendications 1 à 9, **caractérisé en ce que** le dispositif de retenue (19) comprend un diaphragme à iris.

13. Spectromètre RMN selon l'une quelconque des revendications 1 à 5 et 7 à 9, **caractérisé en ce que** le dispositif de retenue (19) présente un élément d'obstruction qui, dans la deuxième position de fonctionnement, empêche le tube à échantillon (14) de se déplacer hors de la position de mesure dans la direction axiale, à la manière d'un couvercle situé au-dessus de l'extrémité, opposée à l'entrée de gaz (18), du tube à échantillon (14).

**14.** Spectromètre RMN selon l'une quelconque des revendications 1 à 9, **caractérisé en ce que** le dispositif de retenue (19) comprend des éléments (25 ; 25') actionnables de manière pneumatique, en particulier gonflables, qui peuvent soumettre le tube à échantillon (14) à une pression radiale dans sa position de mesure.

**15.** Procédé de fonctionnement d'un spectromètre RMN (10) selon l'une quelconque des revendications 9 à 14 comprenant un passeur d'échantillons (32) selon la revendication 5, **caractérisé par** les étapes ci-dessous consistant à :

    (a) faire passer le dispositif de retenue (19) dans la première position de fonctionnement ;
    (b) introduire un tube à échantillon (14) muni d'un échantillon de mesure RMN à travers l'alésage (13) jusqu'à sa position de mesure dans le volume de mesure (12) ;
    (c) détecter la présence du tube à échantillon (14) dans la position de mesure au moyen du premier élément formant capteur (23) ;
    (d) immobiliser le tube à échantillon (14) à l'aide du dispositif de retenue (19) ;
    (e) vérifier la présence effective de la deuxième position de fonctionnement du dispositif de retenue (19) à l'aide de l'élément formant capteur (24) supplémentaire ;
    (f) libérer un flux de gaz de thermorégulation afin de réguler la température de l'échantillon de mesure RMN ;
    (g) effectuer une mesure RMN sur l'échantillon de mesure RMN ;
    (h) faire passer le dispositif de retenue (19) dans la troisième position de fonctionnement et retirer le tube à échantillon (14) du spectromètre (10).

EP 4 363 875 B1

**Fig. 1**

EP 4 363 875 B1

# Fig. 2b

$F_{klemm}$

20

14

# Fig. 2a

16

14

$F_{Gewicht}$

$F_{Stau}$

16

Fig. 3b

Fig. 3a

**Fig. 4b**

19a

16

**Fig. 4a**

24

19a

16

23

Fig. 5

Fig. 6b

Fig. 6a

**Fig. 7**

EP 4 363 875 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102019212508 A1
- DE 102004029633 B4
- DE 102018205535 B3
- EP 3715893 B1
- US 10436859 B2
- EP 3561533 B1
- US 10782369 B2
- US 11073583 B2
- DE 102016203891 A1